# EUROPEAN PATENT SPECIFICATION

(11) **EP 2 088 677 B1**
(45) Date of publication and mention of the grant of the patent: **13.06.2012**
(21) Application number: 09151502.3
(22) Date of filing: 28.01.2009
(51) Int. Cl.: H03M 3/04, H03M 1/12, H03M 3/02

(54) **Analog to digital converters**
Analog/Digital-Umsetzer
Convertisseurs analogique-numériques

(30) Priority: 06.02.2008 US 63744 P; 31.12.2008 US 317939
(43) Date of publication of application: 12.08.2009
(73) Proprietor: O2Micro, Inc., Santa Clara, CA 95054 (US)
(72) Inventor: Li, Guo Xing, Sunnyvale, CA 94089 (US)
(74) Representative: Lippert, Stachow & Partner

(56) References cited:
- EP-A- 0 551 690
- US-A- 5 208 597
- US-A- 5 351 050

## Description

### RELATED APPLICATION

This application claims priority to U.S. provisional application, titled "Multi-channel Analog to Digital Converters", Serial Number 61/063,744, filed on February 6, 2008.

### BACKGROUND

In data acquisition application fields, sometimes multiple analog signals are captured and converted to digital signals over a given time frame simultaneously or parallelly.

In one of the conventional architectures, a sample/hold block is employed for each input channel. All analog signals from the input channels are sampled simultaneously and then enter hold states. During the hold time period, an analog-to digital converter (ADC) can be used to convert the sampled analog values to digital signals sequentially until the sampled signals from all the input channels are converted to digital signals. Some drawbacks exist in this architecture. For instance, multiple sample/hold blocks may be required for multiple channels and the sample/hold blocks can be sensitive to high frequency noises without low-pass filtering capabilities.

In another conventional architecture, each input channel employs an individual ADC. Therefore, multiple ADCs are required in a data acquisition system with multiple input channels. Averaging-type ADCs can be used in this architecture to implement synchronization among multiple input channels. However, power consumption, die area and cost of the data acquisition system can be increased if multiple ADCs are employed. In addition, different ADCs may cause mismatch among multiple in put channels.
In the document US 5,351,050, a single input ADC for converting an analog input signal to a digital output signal is disclosed in which a switched capacitor feedback circuit is employed for minimizing the thermal noise of a switched feedback capacitor. Said ADC comprises an input channel for receiving said analog signal, a sampling circuit coupled to said input channel for sampling said analog signal and for providing a sampled analog signal, and an integrator coupled to said sampling circuit for receiving said sampled analog signal and a feedback signal and for integrating a superposition of said sampled analog signal and said feedback signal. Further, said ADC comprises a feedback circuit coupled to said integrator for generating said digital signal according to an output of said integrator and for sending said feedback signal indicative of said digital signal to said integrator.
In the document EP 0551690A1, a multiplexed ADC is disclosed. Said ADC comprises a plurality of sigmal-delta modulators arranged in parallel to which an analog input signal is applied. Said sigma-delta modulators are controlled by a respective modulator clock and provide a respective modulator digital output signal. Said sigma-delta modulators each comprise an input channel, a sampling circuit, a feedback circuit and an integrator for receiving a sampled analog signal and a feedback signal and for integrating a superposition of said sampled analog signal and said feedback signal. Further, said ADC comprises a signal combining means for combining said modulator digital output signals into an overall digital output signal. Thus, high sampling rates can be achieved in said ADC.

### SUMMARY.

In the present invention, an ADC is provided for converting a plurality of analog signals to a plurality of digital output signals, according to the features of claim 1.

### BRIEF DESCRIPTION OF THE DRAWINGS

Advantages of the present invention will be apparent from the following detailed description of exemplary embodiments thereof, which description should be considered in conjunction with the accompanying drawings, in which:

FIG. 1 illustrates a block diagram of a multi-channel analog to digital converter (ADC), in accordance with one embodiment of the present invention.

FIG. 2 illustrates a timing diagram of signals generated by a multi-channel ADC, in accordance with one embodiment of the invention.

FIG. 3 illustrates a flowchart of operations performed by a multi-channel ADC, in accordance with one embodiment of the present invention.

FIG. 4 illustrates a block diagram of an electronic system.

### DETAILED DESCRIPTION

Reference will now be made in detail to the embodiments of the present invention, examples of which are illustrated in the accompanying drawings. While the invention will be described in conjunction with the embodiments, it will be understood that they are not intended to limit the invention to these embodiments. On the contrary, the invention is intended to cover alternatives, modifications and equivalents, which may be included within the spirit and scope of the invention as defined by the appended claims. Furthermore, in the following detailed description of embodiments of the present invention, numerous specific details are set forth in order to provide a thorough understanding of the present invention. However, it will be recognized by one of ordinary skill in the art that the present invention may be practiced without these specific details. In other instances, well-known methods, procedures, components, and circuits have not been described in detail as not to unnecessarily obscure aspects of the embodiments of the present invention.

Embodiments described herein may be discussed in the general context of computer-executable instructions residing on some form of computer-usable medium, such as program modules, executed by one or more computers or other devices. Generally, program modules include routines, programs, objects, components, data structures, etc., that perform particular tasks or implement particular abstract data types. The functionality of the program modules may be combined or distributed as desired in various embodiments.

By way of example, and not limitation, computer-usable media may comprise computer storage media and communication media. Computer storage media includes volatile and nonvolatile, removable and non-removable media implemented in any method or technology for storage of information such as computer-readable instructions, data structures, program modules or other data. Computer storage media includes, but is not limited to, random access memory (RAM), read only memory (ROM), electrically erasable programmable ROM (EEPROM), flash memory or other memory technology, compact disk ROM (CD-ROM), digital versatile disks (DVDs) or other optical storage, magnetic cassettes, magnetic tape, magnetic disk storage or other magnetic storage devices, or any other medium that can be used to store the desired information.

A multi-channel analog to digital converter (ADC) can convert multiple analog signals from multiple input channels to multiple digital output signals, e.g., multiple analog voltages to multiple digital output voltages, in an interleaved mode. The multi-channel ADC can be used in various data processing applications, such as video systems, audio systems, signal sensors, etc., which may require analog to digital conversions.

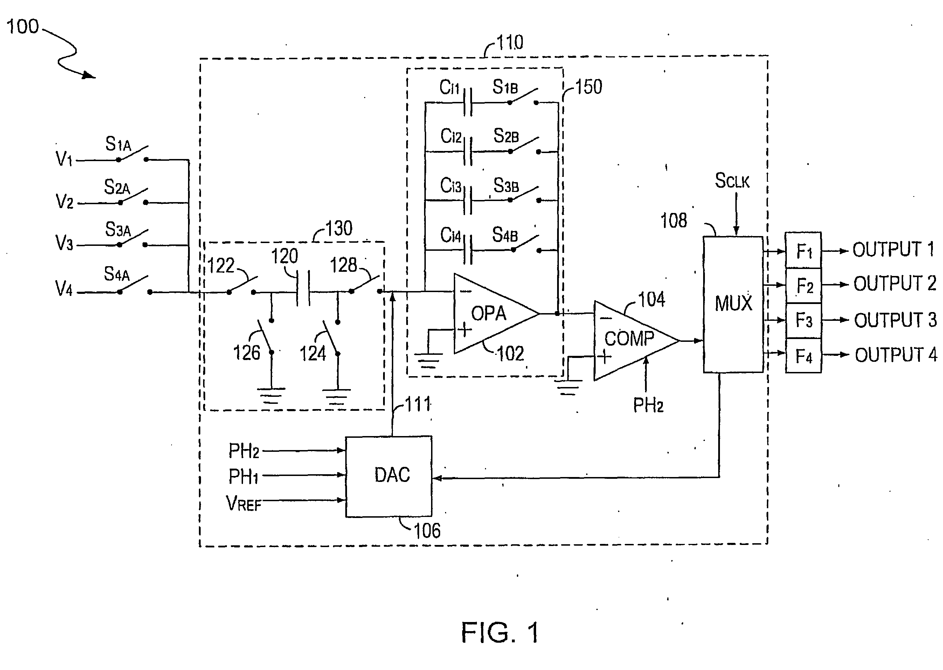

FIG. 1 illustrates a block diagram of a multi-channel ADC 100, in accordance with one embodiment of the present invention. The multi-channel ADC 100 can be a first-order delta-sigma ADC, in one embodiment.

The multi-channel ADC 100 can have multiple input channels, e.g., four input channels including channel 1, channel 2, channel 3, and channel 4 for converting analog signals, e.g., analog voltage signals V1, V2, V3 and V4 respectively to digital signals in an interleaved mode, in one embodiment. Each input channel is coupled to an associated switch, e.g., S1A associated with channel 1, S2A associated with channel 2, S3A associated with channel 3, and S4A associated with channel 4. The switches S1A, S2A, S_{3A}, and·S_{4A} can be controlled by a system clock signal S_{CLK}, in one embodiment. In one embodiment, one input channel is selected during a clock cycle according to the system clock signal S_{CLK}. The switch associated with the selected input channel is turned on and other switches are turned off in one clock cycle, in one embodiment:

The multi-channel ADC 100 includes a modulator 110 for converting analog signals (e.g., the analog voltage signals V₁, V₂, V₃ or V₄) to digital signals. The modulator 110 can be a first-order delta-sigma modulator, or a second-order modulator, etc., according to different application requirements.

The modulator 110 can receive an analog signal from a selected input channel and provide a corresponding digital signal to a filter (e.g., a digital filter F₁, F₂, F₃, or F₄) associated with the input channel. The analog signal can be various types of signals, e.g., current or voltage signals.

The modulator 110 can sample the received analog signal at a predetermined sampling frequency, e.g., a frequency equal to Fs*OSR, where Fs is a Nyquist frequency and OSR is an over sampling ratio to the Nyquist frequency. For example, the sampling frequency is 65536Hz when Fs is 16Hz and OSR is 4096. The analog signal can be translated to a digital signal at the sampling frequency by the modulator 110. In one embodiment, the digital signal can be a continuous 1-bit data stream including logic 1 and logic 0 at a rate determined by the sampling frequency (e.g., Fs*OSR).

In one embodiment, the modulator 110 includes a sampling circuit 130 for sampling the analog signal. The sampling circuit 130 can include an energy storage unit (e.g., sampling capacitor) 120 coupled to the selected input channel for storing charges from the selected input channel, and can include a switch array including switches 122, 124, 126, and 128 for controlling the energy storage unit 120. Switches 122 and 124 are controlled by a signal PH₂, and switches 126 and 128 are controlled by a signal PH₁. The signals PH₁ and PH₂ are non-overlapping clock signals, in one embodiment. For example, when the signal PH₂ is at a high level and the signal PH₁ is at a low level, switches 122 and 124 can be turned on and switches 126 and 128 can be turned off. When the signal PH₁ is at a high level and the signal PH₂ is at a low level, switches 122 and 124 can be turned off and switches 126 and 128 can be turned on.

The modulator 110 can further include an integrator- 150 coupled to the sampling circuit 130 for receiving the sampled analog signal and a feedback signal 111 and for integrating a superposition of the sampled analog signal and the feedback signal 111 and generating an output. In the example of FIG. 1, the integrator 150 includes a group of integrating capacitors (e.g., integrating capacitors Cᵢ₁, Cᵢ₂, Cᵢ₃, and Cᵢ₄) and an error amplifier 102.

The integrating capacitors Cᵢ₁, Cᵢ₂, Cᵢ₃, and Cᵢ₄ are coupled in parallel. The integrating capacitors Cᵢ₁, Cᵢ₂, Cᵢ₃, and Cᵢ₄ can accumulate charges from channel 1, channel 2, channel 3, and channel 4 respectively. Each integrating capacitor Cᵢ₁, Cᵢ₂, Cᵢ₃, or Cᵢ₄ can be coupled to a switch in series, e.g., the integrating capacitor Cᵢ₁ is coupled to a switch S_{1B}, the integrating capacitor Cᵢ₂ is coupled to a switch S_{2B}, the integrating capacitor Cᵢ₃ is coupled to a switch S_{3B}, and the integrating capacitor Cᵢ₄ is coupled to a switch S_{4B}.

In one embodiment, the modulator 110 can complete an analog to digital conversion for each input channel sequentially during a conversion cycle. In one embodiment, the integrating capacitors can be randomly allocated to the input channels at the beginning of a conversion cycle. For example, the integrating capacitor Cᵢ₁ can store charges from channel 2, the integrating capacitor Cᵢ₂ can store charges from channel 3, the integrating capacitor Cᵢ₃ can store charges from channel 4, and the integrating capacitor C₄₁ can store charges from channel 1, etc. The flexible configuration of the input channels and the integrating capacitors can reduce mismatch between different channels caused by mismatch of the integrating capacitors. In one embodiment, the output of the integrator 150 can include the previous charges stored in a corresponding integrating capacitor during a previous conversion cycle and an integration result of the superposition of the sampled analog signal and the feedback signal 111.

In one embodiment, the error amplifier 102 has two input terminals (e.g., an inverting input terminal and a non-inverting input terminal) and an output terminal. The error amplifier 102 can receive an input signal through the inverting input terminal and a first reference signal through the non-inverting input terminal. In one embodiment, the input signal can be a superposition of the sampled analog signal of an input channel and the feedback signal 111. In one embodiment, the non-inverting input terminal is connected to ground such that a voltage level of the first reference signal is substantially equal to zero. The error amplifier 102 can generate an error signal according to a difference between the input signal (e.g., the superposition of the sampled analog signal and the feedback signal 111) and the first reference signal. In one embodiment, the error signal is a voltage signal.

The modulator 110 further includes a feedback circuit for generating a digital signal according to an output of the integrator 150 and for sending the feedback signal 111 indicative of the digital signal to the integrator 150. In the example of FIG. 1, the feedback circuit can include a comparator 104, a multiplexer 108, and a digital to analog converter (DAC) 106. In other words, the integrator 150, the comparator 104, the multiplexer 108, and the DAC 106 together form a feedback loop. The feedback loop includes a feed forward path including the integrator 150, the comparator 104 and the multiplexer 108, and a feed backward path including the DAC 106.

The comparator 104 coupled to the integrator 150 can compare the output of the integrator 150 with a second reference signal and for generating a comparator output - signal according to the comparison result. In one embodiment, the output of the integrator 150 can include the previous charges stored in a corresponding integrating capacitor during a previous conversion cycle and an integration result of the superposition of the sampled analog signal and the feedback signal 111.

The comparator 104 can be controlled by the signal PH₂ and can operate when the signal PH₂ is at a high level. In one embodiment, a non-inverting terminal of the comparator 104 is connected to ground. Thus, a voltage level of the second reference signal is substantially zero. The comparator 104 can generate a 1-bit digital signal (e.g., logic 1 or logic 0) according to the comparison result. The comparator output signal, e.g., a 1-bit digital signal, is further sent to the multiplexer 108.

In one embodiment, the multiplexer 108 can be a barrel shift register controlled by a system clock signal S_{CLK}. The multiplexer 108 can pass the digital signal from the comparator 104, e.g., a 1-bit digital signal, to an output channel, e.g., a digital filter associated with the selected input channel according to the system clock signal S_{CLK}. The output channels can include digital filters F₁, F₂, F₃, and F₄, such as decimation filters to decimate the digital signals (e.g., the 1-bit digital signals from the comparator 104) to multi-bit digital output signals. Therefore, multiple digital output signals associated with the multiple input channels can be obtained from the digital filters (e.g., F₁, F₂, F₃, and F₄), respectively.

Additionally, the multiplexer 108 can latch the 1-bit digital signal from the comparator 104 associated with each input channel. Consequently, during a current conversion cycle, the 1-bit digital signal of each input channel generated in a previous conversion cycle is latched in the multiplexer 108 until a new 1-bit digital signal is generated. When one input channel is selected according to the system clock signal S_{CLK} in the current conversion cycle, the multiplexer 108 can transfer the 1-bit digital signal of the selected input channel which is generated in a previous conversion cycle to the DAC 106. During the first conversion cycle, the multiplexer 108 can transfer a 1-bit digital, e.g., logic 0 to the DAC 106, in one embodiment.

The DAC 106 can be a 1-bit digital to analog converter, in one embodiment. The DAC 106 can receive the 1-bit digital signal from the multiplexer 108 and convert the 1-bit digital signal to an analog signal (e.g., a voltage signal) according to a reference voltage V_{REF}. The analog signal generated by the DAC 106 can be used as the feedback signal 111 sent to the integrator 150. The DAC 106 can set the feedback signal 111 equal to -V_{REF} when the 1-bit digital signal is logic 1 and equal to V_{REF} when the 1-bit digital signal is logic 0, in one embodiment. The DAC 106 can be controlled by signals PH₁ and PH₂. Thus, the value of the feedback signal 111 can be set according to the 1-bit digital signal from the multiplexer 108.

More specifically, when channel 1 is selected according to the system clock signal S_{CLK} in a clock cycle during a current conversion cycle, the modulator 110 can receive the analog signal from channel 1 (e.g., the analog voltage signal V₁) and a feedback signal 111 from the DAC 106, and generate a 1-bit digital signal. In one embodiment, the feedback signal 111 from the DAC 106 is generated according to a 1-bit digital signal of channel 1 generated in a previous conversion cycle and according to a reference voltage V_{REF}. The comparator 104 can generate a 1-bit digital signal to the multiplexer 108. As such, the previous 1-bit digital signal in the multiplexer 108 associated with channel 1 can be replaced by the new 1-bit digital signal generated in the current conversion cycle. The multiplexer 108 can output the 1-bit digital signal generated in the current conversion cycle to the corresponding digital filter F₁. A next input channel, e.g., channel 2, can be selected during a next clock cycle of the system clock signal S_{CLK} and a corresponding 1-bit digital signal can be received by an associated filter. For example, channel 1, channel 2, channel 3, and channel 4 are selected sequentially and 1-bit digital signals corresponding to channel 1, channel 2, channel 3, and channel 4 can be received by the digital filter F₁, the digital filter F₂, the digital filter F₃, and the digital filter F₄ sequentially. The digital filters (e.g., F₁, F₂, F₃, and F₄) can accumulate the 1-bit digital signals for several conversion cycles for corresponding input channels and then can generate multi-bit digital output signals.

Although FIG. 1 shows a multi-channel analog to digital converter 100, the invention is not so limited. For example, the modulator 110 can also be used in a single channel analog to digital converter.

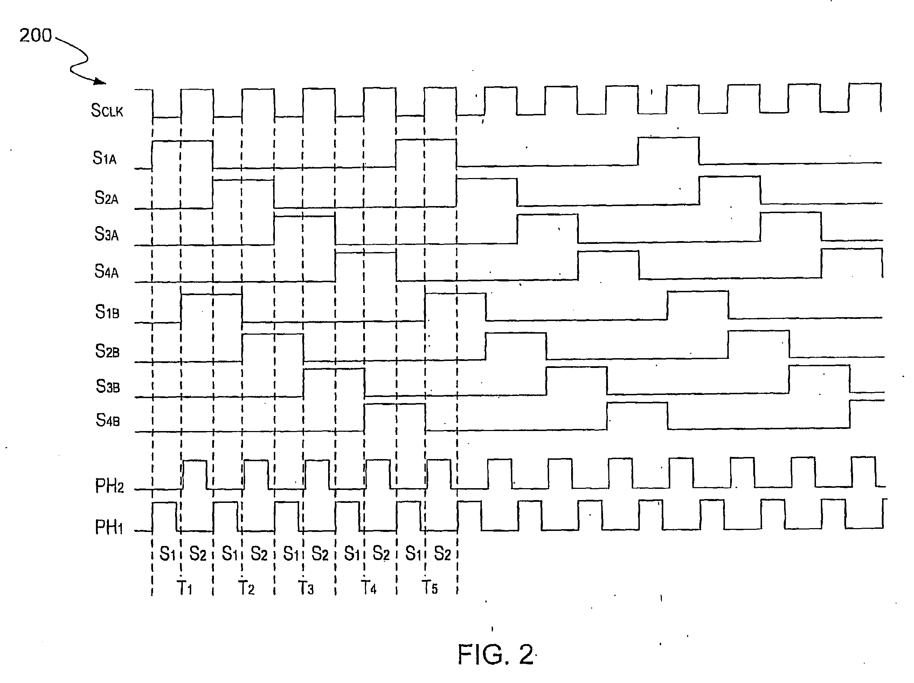

Operations of the multi-channel ADC 100 will be described herein with reference to a timing diagram in FIG. 2 as an example. FIG. 2 illustrates waveforms of the system clock signal S_{CLK}, states of the switches S_{1A}, S_{2A}, S_{3A}, S_{4A}, S_{1B}, S_{2B}, S_{3B}, and S_{4B}, and the signal PH₂ and the signal PH₁ during operations of the multi-channel ADC 100, in one embodiment. FIG. 2 is only for illustrative purposes, and the present invention is not limited to the operation shown in FIG. 2. In the example of FIG. 2, a switch is turned on when a corresponding state waveform is at a high level and the switch is turned off when the corresponding state waveform is at a. low level.

In the example of FIG. 2, a clock cycle of the system clock signal S_{CLK} is divided into two phases including phase S₁ when the system clock signal S_{CLK} is at a low level and phase S₂ when the system clock signal S_{CLK} is at a high level. For instance, each clock cycle, e.g., T₁, T₂, T₃, T₄, T₅, etc., includes phase S₁ and phase S₂. The signal PH₁ is set to a high level and the signal PH₂ is set to a low level during phase S₁ of each clock cycle. Similarly, the signal PH₁ is set to a low level and the signal PH₂ is set to a high level during phase S₂ of each clock cycle. Because the signal PH₁ and the signal PH₂ are non-overlapping clock signals, widths of pulses of the signal PH₁ and the signal PH₂ can be smaller than the widths of the pulses of the system clock signal S_{LCK} to avoid overlapping, in one embodiment.

In one embodiment, channel 1 is first selected after the multi-channel ADC 100 is powered on during the clock cycle T₁. The switches S_{1A} and S_{1B} associated with channel 1 are turned on and switches associated with other input channels (e.g., channel 2, channel 3, and channel 4) are turned off. In one embodiment, the switch S_{1B} is turned on after a delay of half of a clock cycle, e.g., the switch S_{1A} is turned on during the _{.} clock cycle T₁ and the switch S_{1B} is turned on during phase S₂ of the clock cycle T₁ and phase S₁ of the clock cycle T₂. The switches 122 and 124 are turned on during phase S₂ of the clock cycle T₁ according to a high level of the signal PH₂. Simultaneously, the switches 126 and 128 are turned off according to a low level of the signal PH₁ during phase S₂ of the clock cycle T₁. Therefore, the analog signal from channel 1 (e.g., the analog voltage signal V₁) can be transferred to the sampling capacitor 120 via the closed switches S_{1A}, 124 and 122, and can be sampled. Charges from channel 1 corresponding to the analog voltage signal V₁ can be stored in the sampling capacitor 120.

During phase S₁ of the clock cycle T₂, the switches 122 and 124 are turned off according to a low level of the signal PH₂, and the switches 126 and 128 are turned on according to a high level of the signal PH₁. Consequently, the charges stored in the sampling capacitor 120 can be transferred to the integrating capacitor Cᵢ₁ via the closed switches 126, 128 and S_{1B}.

Additionally, the DAC 106 generates a feedback signal 111 to the integrator 150 according to a 1-bit digital signal of channel 1 in a previous conversion cycle. The output of the integrator 150 can be compared with the second reference signal by the comparator 104 when the signal PH₂ is at a high level during phase S₂ of the clock cycle T₂. A 1-bit digital signal of channel 1 can be generated by the comparator 104 and be latched in the multiplexer 108. The digital filter F₁ can receive the 1-bit digital signal.

Channel 2 is selected during the clock cycle T₂. The operating sequence associated with channel 2 is similar to the operating sequence associated with channel 1. Switches S_{2A}, 122, and 124 are turned on and the switches 126 and 128 are turned off according to a high level of the signal PH₂ during phase S₂ of the clock cycle T₂. An analog signal of channel 2 (e.g., an analog voltage signal V₂) can be transferred to the sampling capacitor 120 and be sampled. During phase S₁ of the clock cycle T₃, the switches 122 and 124 are turned off and the switches 126 and 128 are turned on according to a high level of the signal PH₁. Because the switch S_{1B} is turned off after phase Si of the clock cycle T₂ and the switch S_{2B} is turned on during phase S₂ of the clock cycle T₂ and phase S₁ of the clock cycle T₃, charges stored in the sampling capacitor 120 can be transferred to the integrating capacitor C₁₂ during phase S₁ of the clock cycle T₃. Then, the comparator 104 can operate during phase S₂ of the clock cycle T₃ and generate a 1-bit digital signal of channel 2 to the multiplexer 108. The digital filter F₂ can receive the 1-bit digital signal.

Similarly, channel 3 can be selected during the clock cycle T₃ and can generate a 1-bit digital signal during phase S₂ of the clock cycle T₄. Channel 4 can be selected during the clock cycle T₄ and can generate a 1-bit digital signal during phase S₂ of the clock cycle T₅. If more input channels are available, the input channels can be selected sequentially during sequential clock cycles. Thus, the analog signals from the input channels can be converted to digital signals sequentially and circularly. For example, if four input channels exist, at least four clock cycles (e.g., T₁, T₂, T₃, and T₄) can be used to accomplish one conversion cycle for all the input channels. The digital filters (e.g., F₁, F₂, F₃, or F₄) can receive the 1-bit digital signals for the associated input channels (e.g., channel 1, channel 2, channel 3, or channel 4) during each conversion cycle. Then a next conversion cycle starts from the clock cycle T₅. Similarly, each input channel is selected sequentially and each analog signal is sampled sequentially. Consequently, each digital filter can accumulate the 1-bit digital signals of the associated input channel during multiple conversion cycles and decimate the 1-bit digital signals to generate a multi-bit digital output signal at a predetermined rate, e.g., Fs.

Assume that the over sampling ratio is OSR, then the time required for a conversion cycle is N*OSR clocks, where N represents the total number of channels, in one embodiment. Advantageously, in one conversion cycle, the analog signals from the input channels can be sampled and converted to 1-bit digital signals respectively and sequentially, in one embodiment. Thus, multi-bit digital output signals of the multiple input channels can be obtained during multiple conversion cycles in a synchronized way. As a result, the multi-channel ADC 100 has an improved efficiency and reduced power consumption, in one embodiment.

Additionally, in order to speed up the conversions, double sampling technique can be used by adding another switch array (e.g., similar to the switches 122, 124, 126 and 128) and a sampling capacitor (e.g., similar to the sampling capacitor 120) with complementary control clock signals (e.g., PH₁ and PH₂). In this topology, the speed of the ADC conversion can be doubled without increasing static power consumption. Other sampling techniques, e.g., triple sampling technique can also be used to further speed up the conversions of the ADC 100.

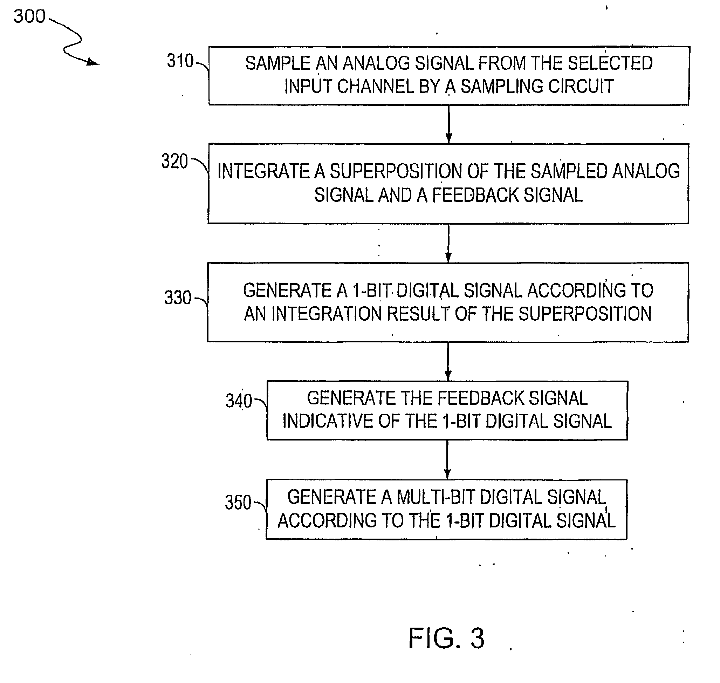

FIG. 3 illustrates a flowchart 300 of operations performed by an ADC, e.g., the multi-channel ADC, in accordance with one embodiment of the present invention. Descriptions of FIG. 3 will be made in combination with FIG. 1. One input channel (e.g., channel 1, channel 2, channel 3, or channel 4) is selected to receive an analog signal by the multi-channel ADC 100 during a clock cycle of the system clock signal S_{CLK}. In block 310, the analog signal from the selected input channel is sampled by a sampling circuit 130 during the same clock cycle under the control of a switch array. In block 320, charges from the sampling capacitor 120 can be transferred to one of the integrating capacitors (e.g., Cᵢ₁, Cᵢ₂, Cᵢ₃ or Cᵢ₄) under the control of an associate switch (e.g., S_{1B}, S_{2B}, S_{3B}, or S_{4B}). The integrator 150 can integrate a superposition of the sampled analog signal and a feedback signal. The integrating capacitors can be randomly allocated to the input channels at the beginning of a conversion cycle. Advantageously, the flexible configuration of the input channels and the integrating capacitors can reduce mismatch among different channels caused by mismatch of the integrating capacitors.

In block 330, a comparator (e.g., the comparator 104) can generate a 1-bit digital signal according to an integration result of the superposition. More specifically, the comparator 104 can compare an integrator output with a reference signal (e.g., the voltage level zero) to generate the 1-bit digital signal, and can send the 1-bit digital signal to the multiplexer 108. The integrator output is generated according to previous charges stored in the corresponding integrating capacitor and according to an integration result of the sampled analog signal and the feedback signal. in block 340, the multiplexer 108 can output the 1-bit digital signal to the DAC 106 and a corresponding digital filter (e.g., F₁, F₂, F₃, or F₄). Hence, the feedback signal 111 can be provided to indicate the 1-bit digital signal. In block 350, the corresponding digital filter can generate a multi-bit digital output signal according to the 1-bit digital signal. More specifically, the corresponding digital filter can accumulate the 1-bit digital signals for several conversion cycles for a corresponding input channel and then can generate the multi-bit digital output signal.

Advantageously, multiple input channels can be selected sequentially and corresponding analog signals thereof can be sampled in block 310. Similarly, the analog signals from other input channels can be converted to digital output signals sequentially via block 310 to block 340. Advantageously, the traditional sample/hold blocks in the multiple input channels due to synchronization sampling can be avoided such that the whole cost of the circuitry can be reduced.

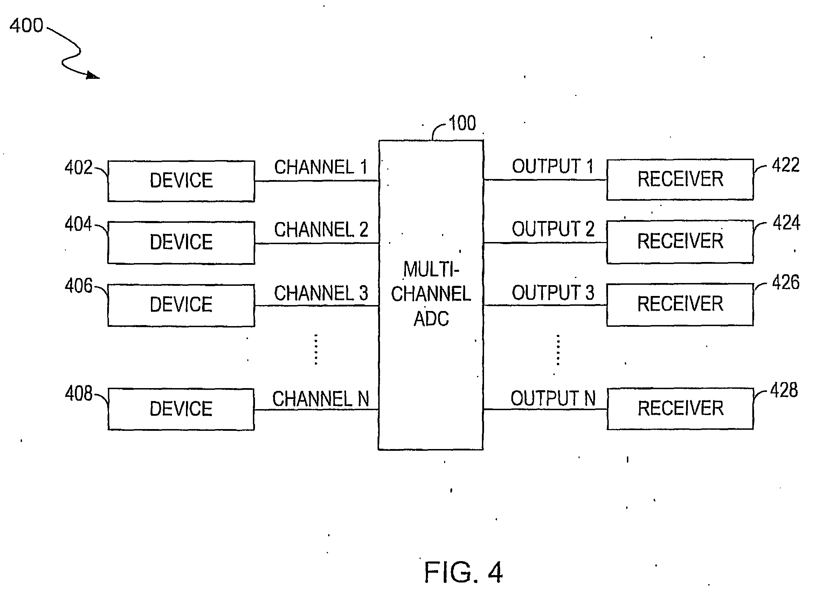

FIG. 4 illustrates a block diagram of an electronic system 400. The electronic system 400 employs the multi-channel ADC 100 disclosed hereinabove, in one embodiment. The multi-channel ADC 100 has multiple input channels (e.g., channel 1, channel 2, channel 3, ..., channel N) for receiving analog signals from multiple devices (e.g., devices 402, 404, 406, ..., 408), and for converting the analog signals to digital output signals (e.g., output 1, output 2, output 3, ..., output N) respectively. The digital output signals can be received by various receivers (e.g., receivers 422, 424, 426, ..., 428). The multi-channel-ADC 100 includes a modulator, e.g., the modulator 110, for converting the analog signals to 1-bit digital signals, and multiple digital filters, e.g., F1, F2, F3, and F4, for generating multi-bit digital output signals according to the 1-bit digital signals. The multiple devices (e.g., the devices 402, 404, 406, .... 408) can be various types of devices, e.g., audio systems, video systems, etc., which can generate analog signals. The receivers (e.g., the receivers 422, 424, 426, ..., 428) can be various types of devices which can receive digital signals. For example, the multi-channel ADC 100 can be used for converting analog voltage monitoring signals indicating battery/cell voltages to digital signals. A battery management system can receive the digital signals and control the battery.

Accordingly, an ADC (e.g., the multi-channel ADC) 100 for converting an analog signal to a digital signal can include multiple input channels (e.g., channel 1, channel 2, channel 3, channel 4, etc.), a sampling circuit 130 coupled to the multiple input channels, an integrator 150 coupled to the sampling circuit 130, and a feedback circuit coupled to the integrator 150, in one embodiment. The multiple input channels can receive an analog signal when the associated switch is turned on. The sampling circuit 130 include an energy storage unit 120 for sampling the analog signal from the selected input channel and includes a switch array for controlling the energy storage unit 120. The integrator 150 can include multiple capacitors (e.g., integrating capacitors) coupled in parallel and an error amplifier 102 coupled to the sampling circuit 130. The integrating capacitors are coupled to multiple switches respectively. One of the integrating capacitors can store charges from the sampling capacitor 120 when the associate switch is turned on.

The feedback circuit can include a comparator 104 coupled to the integrator 150, a multiplexer 108 coupled to the comparator 104, and a DAC 106 coupled to the sampling circuit 130. The comparator 104 can compare an output of the integrator 150 with a reference signal (e.g., zero volts) and generate a comparator output signal according to the comparison result. The multiplexer 108 can provide the digital signal according to the comparator output signal. The DAC 106 can generate a feedback signal 111 according to the digital signal. The multi-channel ADC 110 can further include output channels to provide multi-bit digital output signals.

Advantageously, the multi-channel ADC 100 can perform analog to digital conversions for the multiple input channels in a synchronized and interleaved mode. Multiple sample/hold blocks or multiple ADCs are not required for converting analog signals from multiple input channels, in one embodiment. Hence, the cost of the circuitry can be reduced and the efficiency of the circuitry can be improved. Additionally, the mismatch between multiple ADCs can be reduced/avoided.

The aforementioned embodiments can also be used in a single channel ADC, when one integrating capacitor and an associated switch coupled in series are included in the integrator 150 and one input channel and one digital filter are included in FIG. 1.

## Claims

1. An analog to digital converter (ADC) (100) for converting a plurality of analog signals (V₁, V₂, V₃, V₄) to a plurality of digital output signals (output 1, output2, output 3, output 4), comprising:
a plurality of input channels for receiving said analog signals (V₁, V₂, V₃, V₄);
a sampling circuit (130) .coupled to said plurality of input channels for sampling a corresponding analog signal (V₁, V₂, V₃, V₄ from a selected input channel of said input channels and for providing a sampled analog signal;
an integrator (150) coupled to said sampling circuit (130) for receiving said sampled analog signal and a feedback signal (111) and for integrating a superposition of said sampled analog signal and said feedback signal (111);
a feedback circuit coupled to said integrator (150) for generating a digital signal according to an output of said integrator (150) and for sending said feedback signal indicative of said digital signal to said integrator (150); and
a plurality of output channels coupled to said feedback circuit for generating said digital output signals (output 1, output2, output 3, output 4);
said integrator (150) comprises a plurality of capacitors (Cᵢ₁, Cᵢ₂, Cᵢ₃, Cᵢ₄) coupled in parallel, wherein said capacitors (Cᵢ₁, Cᵢ₂, Cᵢ₃, Cᵢ₄) are coupled to a plurality of switches (S_{1B}, S_{2B}, S_{3B}, S_{4B}), respectively, and wherein one of said plurality of capacitors (Cᵢ₁, Cᵢ₂, Cᵢ₃, Cᵢ₄) stores charges corresponding to said superposition of said sampled analog signal and said feedback signal (111) when an associate switch (S_{1B}, S_{2B}, S_{3B}, S_{4B}) is turned on.

2. The ADC (100) of claim 1, wherein said plurality of input channels are coupled to a plurality of switches (S_{1A}, S_{2A}, S_{3A}, S_{4A}).

3. The ADC (100) of claim 1, wherein said sampling circuit (130) comprises an energy storage unit (120) coupled to said plurality of input channels for storing charges from said selected input channel, and wherein said sampling circuit (130) comprises a switch array coupled to said energy storageunit (120) for controlling said energy storage unit (120).

4. The ADC (100) of claim 1, wherein said integrator (150) comprises an error amplifier (102) coupled to said sampling circuit (130) for comparing a reference signal with said superposition of said feedback signal (111) and said sampled analog signal and for generating an error signal.

5. The ADC (100) of claim 1, wherein said feedback circuit comprises a comparator (104) coupled to said integrator (150) for comparing said output of said integrator (150) with a reference signal and for generating a comparator output signal according to said comparison result.

6. The ADC (100) of claim 5, wherein said feedback circuit comprises a multiplexer (108) coupled to said comparator (104) for providing said digital signal according to said comparator output signal.

7. The ADC (100) of claim 1, wherein said feedback circuit comprises a secondary digital to analog converter (DAC) (106) coupled to said integrator (150) for generating said feedback signal (111).

8. The ADC (100) of claim 1, further comprising:
a filter coupled to said feedback circuit for decimating said digital signal.

9. A method comprising:
receiving a plurality of analog signals (V₁, V₂, V₃, V₄) by a pluralitiy of input channels;
sampling a corresponding analog signal (V₁, V₂, V₃, V₄) from a selected input channel of said plurality of input channels by a sampling circuit (130) to provide a sampled analog signal;
integrating a superposition of said sampled analog signal and a feedback signal (111);
generating a first digital signal according to an integration result of said superposition;
generating said feedback signal (111) indicative of said first digital signal; and
generating a plurality of multi-bit digital output signals (output 1, output2, output 3,
output 4) according to said first digital signal, wherein
said integrating of said superposition of said sampled analog signal and said feedback signal (111) comprises storing charges corresponding to said superposition by one of a plurality of capacitors (Cᵢ₁, Cᵢ₂, Cᵢ₃, Cᵢ₄) that are coupled in parallel, when an associate switch of a plurality of switches (S_{1B}, S_{2B}, S_{3B}, S_{4B}),
which are coupled to said plurality of capacitors (Cᵢ₁, Cᵢ₂, Cᵢ₃, Cᵢ₄), respectively, is turned on.

10. The method of claim 9, wherein integrating said superposition comprises:
comparing a reference signal with said superposition of said feedback signal (111) and said sampled analog signal; and
generating an error signal according to a difference between said reference signal and said superposition.

11. The method of claim 9, wherein generating said first digital signal comprises:
generating an integrator output according to previous charges stored in said integrating capacitor (Cᵢ₁, Cᵢ₂, Cᵢ₃, Cᵢ₄) and according to said integration result of said superposition;
comparing said integrator output with a reference signal; and
generating said first digital signal according to said comparison result.

## Patentansprüche

1. Analog/Digital-Umsetzer (ADU) (100) zur Umsetzung einer Vielzahl von Analogsignalen (V₁, V₂, V₃, V₄) in eine Vielzahl von digitalen Ausgangssignalen (Ausgang 1, Ausgang 2, Ausgang 3, Ausgang 4), umfassend:
eine Vielzahl von Eingangskanälen für den Empfang der Analogsignale (V₁, V₂, V₃, V₄);
eine Abtastschaltung (130), die mit der Vielzahl von Eingangskanälen verbunden ist, zum Abtasten eines entsprechenden Analogsignals (V₁, V₂, V₃, V₄) aus einem gewählten Eingangskanal der Eingangskanäle und
für die Lieferung eines abgetasteten Analogsignals;
einen Integrator (150), der mit der Abtastschaltung (130) verbunden ist,
für den Empfang des abgetasteten Analogsignals und eines Feedbacksignals (111) und zum Integrieren einer Superposition des abgetasteten Analogsignals und des Feedbacksignals (111);
eine Feedbackschaltung, die mit dem Integrator (150) verbunden ist, zum Erzeugen eines Digitalsignals gemäß einer Ausgabe des Integrators (150) und zum Senden eines Feedbacksignals, das auf das Digitalsignal hinweist, an den Integrator (150); und
eine Vielzahl von Ausgangskanälen, die mit der Feedbackschaltung verbunden sind, zur Erzeugung des digitalen Ausgangssignals (Ausgang 1, Ausgang 2, Ausgang 3, Ausgang 4);
wobei der Integrator (150) eine Vielzahl von Kondensatoren (C₁₁, C₁₂, C₁₃, C₁₄) aufweist, die parallelgeschaltet sind, wobei die Kondensatoren (C₁₁, C₁₂, C₁₃, C₁₄) jeweils mit einer Vielzahl von Schaltern (S_{1B}, S_{2B}, S_{3B},
S_{4B}) verbunden sind und wobei einer der Vielzahl von Kondensatoren (C₁₁, C₁₂, C₁₃, C₁₄) Ladungen entsprechend der Superposition des abgetasteten Analogsignals und des Feedbacksignals (111) speichert,
wenn ein zugeordneter Schalter (S_{1B}, S_{2B}, S_{3B}, S_{4B}) aktiviert wird.

2. ADU (100) nach Anspruch 1, wobei die Vielzahl von Eingangskanälen mit einer Vielzahl von Schaltern (S_{1A}, S_{2A}, S_{3A}, S_{4A}) verbunden ist.

3. ADU (100) nach Anspruch 1, wobei die Abtastschaltung (130) eine Energiespeichereinheit (120) umfasst, die zur Speicherung von Ladungen aus den gewählten Eingangskanälen mit der Vielzahl von Eingangskanälen verbunden ist, und wobei die Abtastschaltung (130) ein Schalterarray aufweist, das mit der Energiespeichereinheit (120) verbunden ist, um die Energiespeichereinheit (120) zu steuern.

4. ADU (100) nach Anspruch 1, wobei der Integrator (150) einen Fehlerverstärker (102) aufweist, der mit der Abtastschaltung (130) verbunden ist, um ein Referenzsignal mit der Superposition des Feedbacksignals (111) und des abgetasteten Analogsignals zu vergleichen und ein Fehlersignal zu erzeugen.

5. ADU (100) nach Anspruch 1, wobei die Feedbackschaltung einen Komparator (104) umfasst, der mit dem Integrator (150) verbunden ist, um die Ausgabe des Integrators (150) mit einem Referenzsignal zu vergleichen und ein Komparator-Ausgangssignal zu erzeugen.

6. ADU (100) nach Anspruch 5, wobei die Feedbackschaltung einen Multiplexer (108) umfasst, der mit dem Komparator (104) verbunden ist, um das Digitalsignal gemäß dem Komparator-Ausgangssignal bereitzustellen.

7. ADU (100) nach Anspruch 1, wobei die Feedbackschaltung einen sekundären Digital/Analog-Umsetzer (DAU) (106) umfasst, der mit dem Integrator (150) verbunden ist, um das Feedbacksignal (111) zu erzeugen.

8. ADU (100) nach Anspruch 1, ferner umfassend :
ein Filter, das mit der Feedbackschaltung verbunden ist, um das Digitalsignal zu dezimieren.

9. Verfahren, umfassend :
das Empfangen einer Vielzahl von Analogsignalen (V₁, V₂, V₃, V₄) durch eine Vielzahl von Eingangskanälen;
das Abtasten eines entsprechenden Analogsignals (V₁, V₂, V₃, V₄) aus einem gewählten Eingangskanal der Vielzahl von Eingangskanälen durch eine Abtastschaltung (130), um ein abgetastetes Analogsignal zu liefern;
das Integrieren einer Superposition des abgetasteten Analogsignals und
eines Feedbacksignals (111);
das Erzeugen eines ersten Digitalsignals gemäß einem Integrationsergebnis der Superposition;
das Erzeugen eines Feedbacksignals (111), das auf das erste Digitalsignal hinweist; und
das Erzeugen einer Vielzahl von digitalen Multibit-Ausgangssignalen (Ausgang 1, Ausgang 2, Ausgang 3, Ausgang 4) gemäß dem ersten Digitalsignal, wobei
die Integration der Superposition des abgetasteten Analogsignals und
des Feedbacksignals (111) die Speicherung von Ladungen entsprechend der Superposition durch einen einer Vielzahl von parallelgeschalteten Kondensatoren (C₁₁, C₁₂, C₁₃, C₁₄) umfasst, wenn ein zugeordneter Schalter einer Vielzahl von Schaltern (S_{1B}, S_{2B}, S_{3B}, S_{4B}), die jeweils mit der Vielzahl von Kondensatoren (C₁₁, C₁₂, C₁₃, C₁₄) verbunden sind, aktiviert wird.

10. Verfahren nach Anspruch 9, wobei das Integrieren der Superposition umfasst :
das Vergleichen eines Referenzsignals mit der Superposition des Feedbacksignals (111) und des abgetasteten Analogsignals; und
das Erzeugen eines Fehlersignals gemäß einer Differenz zwischen dem Referenzsignal und der Superposition.

11. Verfahren nach Anspruch 9, wobei das Erzeugen des ersten Digitalsignals umfasst:
das Erzeugen einer Integrator-Ausgabe gemäß in dem integrierenden Kondensator (C₁₁, C₁₂, C₁₃, C₁₄) vorher gespeicherten Ladungen und
gemäß dem Ergebnis der Superposition;
Vergleichen der Integrator-Ausgabe mit einem Referenzsignal; und
Erzeugen des ersten Digitalsignals gemäß dem Vergleichsergebnis.

## Revendications

1. Convertisseur analogique-numérique (CAN) (100) pour convertir une pluralité de signaux analogiques (V₁, V₂, V₃, V₄) en une pluralité de signaux numériques de sortie (sortie 1, sortie 2, sortie 3, sortie 4), comprenant :
une pluralité de canaux d'entrée pour recevoir lesdits signaux analogiques (V₁, V₂, V₃, V₄) ;
un circuit de balayage (130) couplé à la pluralité de canaux d'entrée pour balayer un signal analogique correspondant (V₁, V₂, V₃, V₄) d'un canal d'entrée sélectionné des canaux d'entrée et pour fournir un signal balayé analogique ;
un intégrateur (150) couplé audit circuit de balayage (130) pour recevoir ledit signal analogique balayé et un signal de retour (111) et pour intégrer une superposition dudit signal analogique balayé et dudit signal de retour (111) ;
un circuit de retour couplé audit intégrateur (150) pour produire un signal numérique selon une sortie de l'intégrateur (150) et pour envoyer ledit signal de retour indicatif au signal numérique à l'intégrateur (150) ; et
une pluralité de canaux de sortie couplés au circuit de retour pour produire lesdits signaux numériques de sortie (sortie 1, sortie 2, sortie 3, sortie 4) ;
ledit intégrateur (150) comprenant une pluralité de condensateurs (C₁₁, C₁₂, C₁₃, C₁₄) connectés parallèlement l'un à l'autre, lesdits condensateurs (C₁₁, C₁₂, C₁₃, C₁₄) respectivement étant couplés à une pluralité d'interrupteurs (S_{1B}, S_{2B}, S_{3B}, S_{4B}), et l'un de la pluralité de condensateurs (C₁₁, C₁₂, C₁₃, C₁₄) accumulant des charges qui correspondent à ladite superposition dudit signal analogique balayé et dudit signal de retour (111) lorsqu'un interrupteur (S_{1B}, S_{2B}, S_{3B}, S_{4B}) associé est activé.

2. CAN (100) selon la revendication 1, dans lequel la pluralité de canaux d'entrée sont couplés à une pluralité d'interrupteurs (S_{1A}, S_{2A}, S_{3A}, S_{4A}).

3. CAN (100) selon la revendication 1, dans lequel le circuit de balayage (130) comporte une unité d'accumulation d'énergie (120) couplée à la pluralité de canaux d'entrée pour accumuler des charges dudit canal d'entrée sélectionné et dans lequel le circuit de balayage (130) comporte un array d'interrupteurs couplé à ladite unité d'accumulation d'énergie (120) pour commander ladite unité d'accumulation d'énergie (120).

4. CAN (100) selon la revendication 1, dans lequel l'intégrateur (150) comporte un amplificateur d'erreur (102) couplé audit circuit de balayage (130) pour comparer un signal de référence avec la superposition dudit signal de retour (111) et ledit signal analogique balayé et pour produire un signal d'erreur.

5. CAN (100) selon la revendication 1, dans lequel le circuit de retour comporte un comparateur (104) couplé à l'intégrateur (150) pour comparer ladite sortie de l'intégrateur (150) avec un signal de référence et pour produire un signal de sortie du comparateur selon le résultat de la comparaison.

6. CAN (100) selon la revendication 5, dans lequel le circuit de retour comporte un multiplexeur (108) couplé audit comparateur (104) pour fournir ledit signal numérique selon le signal de sortie du comparateur.

7. CAN (100) selon la revendication 1, dans lequel le circuit de retour comporte un deuxième convertisseur numérique-analogique (CNA) (106) couplé audit intégrateur (150) pour produire ledit signal de retour (111).

8. CAN (100) selon la revendication 1, comprenant en outre :
un filtre couplé audit circuit de retour pour décimer ledit signal numérique.

9. Procédé, comprenant les étapes de :
recevoir une pluralité de signaux analogiques (V₁, V₂, V₃, V₄) par une pluralité de canaux d'entrée ;
balayer un signal analogique correspondant (V₁, V₂, V₃, V₄) d'un canal d'entrée sélectionné de la pluralité de canaux d'entrée par un circuit de balayage (130) et fournir un signal analogique balayé ;
intégrer une superposition dudit signal analogique balayé et dudit signal de retour (111) ;
produire un premier signal numérique selon un résultat de l'intégration de ladite superposition ;
produire ledit signal de retour (111) indicatif au premier signal numérique ; et
produire une pluralité de signaux numériques à bits multiples de sortie (sortie 1, sortie 2, sortie 3, sortie 4) selon le premier signal numérique,
ladite intégration de la superposition dudit signal analogique balayé et
dudit signal de retour (111) comprenant l'étape d'accumuler des charges correspondant à ladite superposition par l'un des condensateurs (C₁₁, C₁₂, C₁₃, C₁₄) couplés parallèlement l'un à l'autre lorsqu'un interrupteur associé de la pluralité d'interrupteurs (S_{1B}, S_{2B}, S_{3B}, S_{4B}) respectivement couplés à la pluralité de condensateurs (C₁₁, C₁₂, C₁₃, C₁₄) est activé.

10. Procédé selon la revendication 9, dans lequel l'intégration de ladite superposition comprend les étapes de :
comparer un signal de référence avec ladite superposition dudit signal de retour (111) et dudit signal analogique balayé ; et
produire un signal d'erreur selon la différence entre ledit signal de référence et ladite superposition.

11. Procédé selon la revendication 9, dans lequel la production du premier signal numérique comprend les étapes de :
produire une sortie de l'intégrateur selon les charges précédentes accumulées dans le condensateur intégréant (C₁₁, C₁₂, C₁₃, C₁₄) et selon le résultat de l'intégration de la superposition ;
comparer la sortie de l'intégrateur avec un signal de référence ; et
produire ledit premier signal numérique selon le résultat de ladite comparaison.
